# EUROPEAN PATENT APPLICATION

(11) **EP 4 818 721 A1**
(43) Date of publication of application: **07.10.2026**
(21) Application number: 26169122.4
(22) Date of filing: 30.03.2026
(51) Int. Cl.: G01R 31/388, B60L 58/12, B60L 58/22, H01M 10/44

(54) **APPARATUS AND METHOD FOR ESTIMATING CAPACITY DISPERSION OF BATTERY CELL**

(30) Priority: 01.04.2025 KR 20250042124
(71) Applicant: SAMSUNG SDI CO., LTD., Yongin-si, Gyeonggi-do 17084 (KR)
(72) Inventor: HWANG, Yong Jun, 16678 Suwon-si, Gyeonggi-do (KR)
(74) Representative: Gulde & Partner

(57) **Abstract**

An apparatus and method for estimating capacity dispersion of a battery cell, in which a relative capacity difference between battery cells in a battery pack is extracted using charge and discharge data in an actual use environment, includes a processor, and a memory configured to store instructions executed by the processor, wherein the processor calculates a partial capacity of each battery cell with respect to a common operating voltage range of the battery cells based on a voltage of each battery cell, and estimates the capacity dispersion of the battery cell using the partial capacity of each battery cell.

## Description

### BACKGROUND

### Field

The present invention relates to an apparatus and method for estimating capacity dispersion of a battery cell.

### Description of Related Art

Recently, a cloud battery management system (BMS), which allows a state of a battery pack to be transmitted to and stored in a higher-level system, such as a server or the like, for storage, and then estimate an internal state of a battery through more precise and complex calculations, has emerged. Accordingly, by using data stored over a longer time than that in an on-board BMS of a battery pack, various types of battery states may be estimated.

When the internal state of the battery pack is estimated, the internal state of not only the entire battery pack but also the individual battery cells constituting the battery pack is estimated, which serves as a critical variable in controlling the nonuniformity of battery cells in the battery pack.

The battery cell state estimation is performed based on the assumption that all battery cells are identical, as capacity differences between the cells cannot be accounted for. Accordingly, errors caused by the assumption occur in key state estimations. That is, since the capacity of the battery cell is estimated based on a single capacity, an error with respect to the actual capacity may occur.

The herein information disclosed in this Background section is for enhancement of understanding of the background of the present invention, and therefore, it may contain information that does not constitute related (or prior) art.

### SUMMARY

According to a fist aspect of the present invention, there is provided an apparatus for estimating capacity dispersion of a battery cell, which includes a data collection unit configured to collect a state of a battery cell, a processor, and a memory configured to store instructions executed by the processor, wherein the processor calculates a partial capacity of each battery cell with respect to a common operating voltage range of battery cells based on a voltage of each battery cell, and estimates the capacity dispersion of the battery cell using the partial capacity of each battery cell.

In some embodiments, the capacity dispersion of the battery cell is estimated for each charge capacity or discharge capacity of the battery cell.

In some embodiments, voltage information of the battery cell includes an H parameter of the battery cell.

In some embodiments, the common operating voltage range is a voltage range in which the battery cells operate commonly and is set based on an operating voltage range of the battery cell.

In some embodiments, the processor divides the common operating voltage range into a charge cycle and a discharge cycle using the H parameter of the battery cell.

In some embodiments, in a case of the discharge cycle, the common operating voltage range is a range between an operating upper limit voltage of a battery cell having a lowest operating voltage range among the battery cells and an operating lower limit voltage of a battery cell having a highest operating voltage range among the battery cells.

In some embodiments, in a case of the charge cycle, the common operating voltage range is a range between an operating lower limit voltage of a battery cell having a highest operating voltage range among the battery cells and an operating upper limit voltage of a battery cell having a lowest operating voltage range among the battery cells.

In some embodiments, the processor estimates the capacity dispersion of the battery cell based on a ratio of the partial capacity of each battery cell to the common operating voltage range.

In some embodiments, the capacity dispersion of the battery cell is represented by a percentage of the partial capacity of each battery cell with respect to an average partial capacity of the battery cells.

The present invention is set out in the appended set of claims, wherein the drawings and respective description relate to advantageous embodiments thereof.

According to a second aspect of the present invention, there is provided a method of estimating capacity dispersion of a battery cell, the method comprising: calculating, by a processor, a partial capacity of each battery cell with respect to a common operating voltage range of battery cells based on voltage information of each battery cell, and estimating, by the processor, the capacity dispersion of the battery cell using the partial capacity of each battery cell.

In some embodiments, the capacity dispersion of the battery cell is estimated for each charge capacity or discharge capacity of the battery cell.

In some embodiments, the voltage information of the battery cell includes an H parameter of the battery cell.

In some embodiments, the common operating voltage range is a voltage range in which the battery cells operate commonly and is set based on an operating voltage range of the battery cell.

In some embodiments, the processor divides the common operating voltage range into a charge cycle and a discharge cycle using an H parameter of the battery cell.

In some embodiments, in a case of the discharge cycle, the common operating voltage range is a range between an operating upper limit voltage of a battery cell having a lowest operating voltage range among the battery cells and an operating lower limit voltage of a battery cell having a highest operating voltage range among the battery cells.

In some embodiments, in a case of the charge cycle, the common operating voltage range is a range between an operating lower limit voltage of a battery cell having a highest operating voltage range among the battery cells and an operating upper limit voltage of a battery cell having a lowest operating voltage range among the battery cells.

In some embodiments, in the estimating of the capacity dispersion of the battery cell,
the processor estimates the capacity dispersion of the battery cell based on a ratio of the partial capacity of each battery cell to the common operating voltage range.

In some embodiments, the capacity dispersion of the battery cell is represented by a percentage of the partial capacity of each battery cell with respect to an average partial capacity of the battery cells.

### BRIEF DESCRIPTION OF THE DRAWINGS

The following drawings attached to the present specification illustrate various exemplary embodiments of the present invention and further describe aspects and features of the present invention together with the detailed description of the present invention. Thus, the present invention should not be construed as being limited to the drawings, in which:
FIG. 1 is a block diagram of an apparatus for estimating capacity dispersion of a battery cell according to embodiments of the present invention;
FIG. 2 is a view illustrating a state of charge (SOC)-open circuit voltage (OCV) characteristic curve according to embodiments of the present invention;
FIG. 3 is a view illustrating a capacity (Ah)-OCV characteristic curve according to embodiments of the present invention;
FIG. 4 is a view illustrating a vehicle battery pack current according to embodiments of the present invention;
FIG. 5 is a view illustrating voltages of the battery cells according to embodiments of the present invention;
FIG. 6 is a view illustrating the H parameter characteristics of the battery cells according to embodiments of the present invention;
FIG. 7 is a veiw illustrating dispersion estimation results of the battery cells according to embodiments of the present invention; and
FIG. 8 is a flowchart of a method of estimating capacity dispersion of a battery cell according to embodiments of the present invention.

### DETAILED DESCRIPTION

Hereinafter, embodiments of the present invention will be described, in detail, with reference to the accompanying drawings. The terms or words used in this specification and claims should not be construed as being limited to the usual or dictionary meaning and should be interpreted as meaning and concept consistent with the technical idea of the present invention based on the principle that the inventor can be his/her own lexicographer to appropriately define the concept of the term to explain his/her invention in the best way.

The embodiments described in this specification and the configurations shown in the drawings are only some of the embodiments of the present invention and do not represent all of the technical ideas, aspects, and features of the present invention. Accordingly, it should be understood that there may be various equivalents and modifications that can replace or modify the embodiments described herein at the time of filing this application.

It will be understood that when an element or layer is referred to as being "on," "connected to," or "coupled to" another element or layer, it may be directly on, connected, or coupled to the other element or layer or one or more intervening elements or layers may also be present. When an element or layer is referred to as being "directly on," "directly connected to," or "directly coupled to" another element or layer, there are no intervening elements or layers present. For example, when a first element is described as being "coupled" or "connected" to a second element, the first element may be directly coupled or connected to the second element or the first element may be indirectly coupled or connected to the second element via one or more intervening elements.

In the figures, dimensions of the various elements, layers, etc. may be exaggerated for clarity of illustration. The same reference numerals designate the same elements. As used herein, the term "and/or" includes any and all combinations of one or more of the associated listed items. Further, the use of "may" when describing embodiments of the present invention relates to "one or more embodiments of the present invention." Expressions, such as "at least one of" and "any one of," when preceding a list of elements, modify the entire list of elements and do not modify the individual elements of the list. When phrases such as "at least one of A, B and C, "at least one of A, B or C," "at least one selected from a group of A, B and C," or "at least one selected from among A, B and C" are used to designate a list of elements A, B and C, the phrase may refer to any and all suitable combinations or a subset of A, B and C, such as A, B, C, A and B, A and C, B and C, or A and B and C. As used herein, the terms "use," "using," and "used" may be considered synonymous with the terms "utilize," "utilizing," and "utilized," respectively. As used herein, the terms "substantially," "about," and similar terms are used as terms of approximation and not as terms of degree, and are intended to account for the inherent variations in measured or calculated values that would be recognized by those of ordinary skill in the art.

It will be understood that, although the terms first, second, third, etc. may be used herein to describe various elements, components, regions, layers, and/or sections, these elements, components, regions, layers, and/or sections should not be limited by these terms. These terms are used to distinguish one element, component, region, layer, or section from another element, component, region, layer, or section. Thus, a first element, component, region, layer, or section discussed herein could be termed a second element, component, region, layer, or section without departing from the teachings of example embodiments.

Spatially relative terms, such as "beneath," "below," "lower," "above," "upper," and the like, may be used herein for ease of description to describe one element or feature's relationship to another element(s) or feature(s) as illustrated in the figures. It will be understood that the spatially relative terms are intended to encompass different orientations of the device in use or operation in addition to the orientation depicted in the figures. For example, if the device in the figures is turned over, elements described as "below" or "beneath" other elements or features would then be oriented "above" or "over" the other elements or features. Thus, the term "below" may encompass both an orientation of above and below. The device may be otherwise oriented (rotated 90 degrees or at other orientations), and the spatially relative descriptors used herein should be interpreted accordingly.

The terminology used herein is for the purpose of describing embodiments of the present invention and is not intended to be limiting of the present invention. As used herein, the singular forms "a" and "an" are intended to include the plural forms as well, unless the context clearly indicates otherwise. It will be further understood that the terms "includes," "including," "comprises," and/or "comprising," when used in this specification, specify the presence of stated features, integers, steps, operations, elements, and/or components but do not preclude the presence or addition of one or more other features, integers, steps, operations, elements, components, and/or groups thereof.

Also, any numerical range disclosed and/or recited herein is intended to include all sub-ranges of the same numerical precision subsumed within the recited range. For example, a range of "1.0 to 10.0" is intended to include all subranges between (and including) the recited minimum value of 1.0 and the recited maximum value of 10.0, that is, having a minimum value equal to or greater than 1.0 and a maximum value equal to or less than 10.0, such as, for example, 2.4 to 7.6. Any maximum numerical limitation recited herein is intended to include all lower numerical limitations subsumed therein, and any minimum numerical limitation recited in this specification is intended to include all higher numerical limitations subsumed therein. Accordingly, Applicant reserves the right to amend this specification, including the claims, to expressly recite any sub-range subsumed within the ranges expressly recited herein.

References to two compared elements, features, etc. as being "the same" may mean that they are "substantially the same". Thus, the phrase "substantially the same" may include a case having a deviation that is considered low in the art, for example, a deviation of 5% or less. In addition, when a certain parameter is referred to as being uniform in a given region, it may mean that it is uniform in terms of an average.

Throughout the specification, unless otherwise stated, each element may be singular or plural.

When an arbitrary element is referred to as being disposed (or located or positioned) on the "above (or below)" or "on (or under)" a component, it may mean that the arbitrary element is placed in contact with the upper (or lower) surface of the component and may also mean that another component may be interposed between the component and any arbitrary element disposed (or located or positioned) on (or under) the component.

In addition, it will be understood that when an element is referred to as being "coupled," "linked" or "connected" to another element, the elements may be directly "coupled," "linked" or "connected" to each other, or an intervening element may be present therebetween, through which the element may be "coupled," "linked" or "connected" to another element. In addition, when a part is referred to as being "electrically coupled" to another part, the part can be directly connected to another part or an intervening part may be present therebetween such that the part and another part are indirectly connected to each other.

Throughout the specification, when "A and/or B" is stated, it means A, B or A and B, unless otherwise stated. That is, "and/or" includes any or all combinations of a plurality of items enumerated. When "C to D" is stated, it means C or more and D or less, unless otherwise specified.

The present invention is directed to providing an apparatus and method for estimating capacity dispersion of a battery cell, in which a relative capacity difference between battery cells in a battery pack is extracted using charge/discharge data in an actual usage environment.

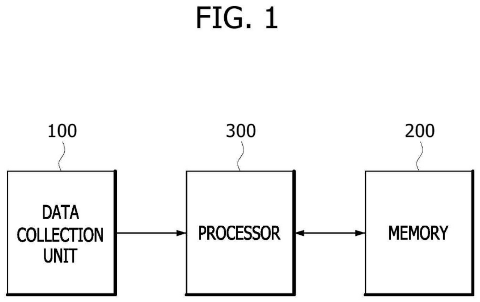

FIG. 1 is a block diagram of an apparatus for estimating capacity dispersion of a battery cell according to embodiments of the present invention.

Referring to FIG. 1, an apparatus for estimating capacity dispersion of a battery cell according to embodiments of the present invention includes a data collection unit 100, a memory 200, and a processor 300.

The data collection unit 100 collects a state of a battery cell (not illustrated). The state of the battery cell may be a voltage, current, or temperature of the battery cell, but is not particularly limited thereto.

A battery (not illustrated) may include a plurality of battery cells, which may be connected in series, in parallel, or in a combination of series and parallel. The battery cell may be a rechargeable secondary battery. For example, the battery cell may include a nickel-cadmium battery, a lead-acid battery, a nickel-metal hydride (NiMH) battery, a lithium-ion battery, a lithium polymer battery, etc. The number of battery cells may be determined according to a required output voltage.

The battery cells may be connected to a load and/or a charge device via external terminals and may be discharged to supply electric power to the load or charged by receiving electric power from the charge device.

The data collection unit 100 may be a server or database that collects and stores the state of the battery cells, a battery cell sensor for detecting the state of the battery cells, or a communication interface that receives the state of the battery cells from the battery cell sensor.

Here, the battery cell sensor for detecting the state of the battery cells may include a voltage sensor, a current sensor, and a temperature sensor.

The voltage sensor may be connected to both terminals of the battery cell and may periodically measure voltages of the battery cells. For example, the voltage sensor may measure the voltage of both terminals of the battery at a first time period (Δt), and a currently or recently measured voltage may be referred to as a current voltage and denoted by V(t). In addition, a voltage measured before the first time period (Δt) may be referred to as a previous voltage and denoted by V(t-1). The first time period (Δt) may be, for example, 1 second. However, this is illustrative, and the first time period (Δt) may be set to a different time. For example, the first time period (Δt) may be set to 0.1 seconds, 0.5 seconds, 2 seconds, 5 seconds, 10 seconds, etc. The first time period (Δt) may be appropriately set depending on an electrical system in which a battery is used.

The current sensor may periodically measure the current of the battery cell in use to generate current. The voltage sensor and the current sensor may be synchronized to measure a voltage and current of the battery cell at the same time, respectively. The current sensor may also measure a current of the battery at the first time period (Δt). The current measured by the current sensor may be indicated as positive (+) when it is a charge current and as negative (-) when it is a discharge current. A currently or recently measured current may be referred to as a present current and denoted by I(t), and a current measured prior to the first time period (Δt) may be referred to as a previous current and denoted by I(t-1).

The memory 200 may store various data used by the processor 300. The data may include instructions for performing operations, steps, etc., according to various embodiments of the present invention. That is, the memory 200 may store instructions to calculate the partial capacity of each battery cell with respect to a common operating voltage range of the battery cells based on the voltage of each battery cell and to estimate the capacity dispersion of the battery cell using the partial capacity of each battery cell. In addition, the memory 200 may store the state of the battery cells and G and H parameters. The common operating voltage range, the partial capacity of each battery cell, the G and H parameters will be described herein.

The memory 200 may include at least one of a flash memory type, hard disk type, multimedia card micro type, and card-type memory, a random access memory (RAM), a static RAM (SRAM), a read-only memory (ROM), a programmable ROM (PROM), an erasable PROM (EPROM), and an electrically EPROM (EEPROM).

The processor 300 may be connected to the memory 200 and may execute the instructions stored in the memory 200. The processor 300 may execute the instructions stored in the memory 200 to control at least one other component (e.g., a hardware or software component) connected to the processor 300 and perform various data processing or calculations.

In addition, the processor 300 may be configured such that components for performing each function are separately configured at a hardware, software, or logic level. In this case, dedicated hardware may be used to perform each function. To this end, the processor 300 may be implemented as at least one of, or include at least one of, an application specific integrated circuit (ASIC), a digital signal processor (DSP), a programmable logic device (PLD), a field programmable gate array (FPGA), a central processing unit (CPU), a microcontroller, and/or a microprocessor.

The processor 300 may be implemented as a CPU or system on chip (SoC), may control a plurality of hardware or software components connected to the processor 300 by driving an operating system or application, and perform processing and calculation on various types of data. The processor 300 may be configured to execute at least one command stored in the memory 200 (not illustrated) and store execution result data in the memory.

The processor 300 may collect the state of the battery cells from the data collection unit 100. The processor 300 calculates the partial capacity of each battery cell with respect to the common operating voltage range of the battery cells based on the voltage of the collected states of the battery cells and estimates the capacity dispersion of the battery cell using the partial capacity of each battery cell. In an embodiment, the capacity dispersion of the battery cell may be estimated for each charge capacity or discharge capacity of the battery cell. In a further embodiment, the common operating voltage range is a voltage range in which the battery cells operate commonly and is set based on an operating voltage range of the battery cell.

The processor 300 may be included in a battery management system (BMS) of the battery pack. In another example, the processor 300 may be included in a BMS or electronic control unit (ECU) of an electric vehicle. In still another example, the processor 300 may be included in a controller of an energy storage system. In yet another example, the processor 300 may be implemented as the processor 300 for a server communicatively connected to the BMS or the energy storage system.

Specifically, the processor 300 may generate G and H parameters in real time using the state of the battery cell.

The G parameter may indicate the sensitivity of a voltage to changes in a current of a battery cell. The G parameter is a state quantity indicating the sensitivity of a terminal voltage to changes in an applied current of a battery cell in use and may have a unit of resistance. The H parameter may indicate an effective potential determined by the local equilibrium potential dispersion and resistance dispersion in the battery cell. The H parameter may be the effective potential determined by the local equilibrium potential dispersion and resistance dispersion within the battery cell in use.

The processor 300 may use an adaptive filter to generate the G and H parameters from the voltage and current of the battery cell. In an embodiment, voltage information of the battery cell may include the H parameter of the battery cell.

The adaptive filter may use a recursive least squares (RLS) method or a weighted least squares (WLS) method.

The G and H parameters of the battery cell may be quantified as explicit correlation equations of material properties and design variables of the battery cell based on a theoretical model. Accordingly, an internal state of the battery cell can be easily estimated from the G and H parameters. The G and H parameters of the battery cell will be described herein.

It may be assumed that a voltage (V) and current (i) of a battery cell have a relationship represented by V=f(i; x, p). Here, x denotes a physical quantity representing the internal state of the battery cell, and p denotes a parameter.

The function (f) is a nonlinear implicit function, and when the function (f) may be divided into a rapidly varying quantity (g) and a slowly varying quantity (h), the herein relationship may be represented by V=g(i; x, p)+h(i; x, p).

When it is assumed that a slowly varying function G(i; x, p)=dg/di with respect to the current (i) is present, the herein relationship may be represented by V=G(i; x, p)i+H(i; x, p).

In the herein relationship, dG/di and dH/di have very small values. That is, when the assumptions are satisfied, since G and H are slowly varying functions with respect to the current (i), the function (f) representing the nonlinear relationship between the voltage (V) and the current (i) may be represented by a quasi-linear relationship, as in the herein relationship.

Here, G is referred to as the G parameter, and H is referred to as the H parameter. When the current (i) is the charging/discharge current and Ueq is the equilibrium potential of the battery cell, a discharge overvoltage may be represented by Ueq-V=-G.i+(Ueq-H) using the G parameter (G) and the H parameter (H).

Here, -G.i may be an overvoltage generated by the battery cell to allow current to flow through terminals. (Ueq-H) is an overvoltage generated due to a deviation of a local thermodynamic equilibrium state of the battery cell from an equilibrium state of the overall system. That is, (Ueq-H) represents inefficiency caused by thermodynamic imbalance within the battery, and when the internal system of the battery reaches thermodynamic equilibrium, the H parameter (H) becomes equal to an equilibrium potential (Ueq).

The processor 300 may use the generated H parameter of each battery cell to separate charge and discharge cycles.

The processor 300 may search for the common operating voltage range of the charge or discharge cycle for each battery cell. That is, the processor 300 may search for the common operating voltage range for each charge and discharge cycle for each battery cell.

The common operating voltage range may be a voltage range in which battery cells operate commonly, that is, charged or discharged. Accordingly, the common operating voltage range may be divided into a common operating voltage range of the charge cycle and a common operating voltage range of the discharge cycle. In an embodiment, the processor 300 may divide the common operating voltage range into a charge cycle and a discharge cycle using the H parameter of the battery cell.

The common operating voltage range of the discharge cycle may be a range between an operating upper limit voltage of the battery cell having the lowest operating voltage range among the battery cells and an operating lower limit voltage of the battery cell having the highest operating voltage range among the battery cells.

The common operating voltage range of the charge cycle may be a range between the operating lower limit voltage of the battery cell having the highest operating voltage range among the battery cells and the operating upper limit voltage of the battery cell having the lowest operating voltage range among the battery cells.

In general, the common operating voltage ranges may be extracted for each of the charge and discharge cycles because battery cells of the same model may have the same discharge and charge characteristics. States of charge (SOC)-open circuit voltage (OCV) characteristics of battery cells are basically the same.

Ideally, all battery cells in a battery pack need to operate under the conditions of the same capacity and the same state. However, actual battery cells constituting a battery pack exhibit capacity differences, and their operating ranges also slightly differ from each other.

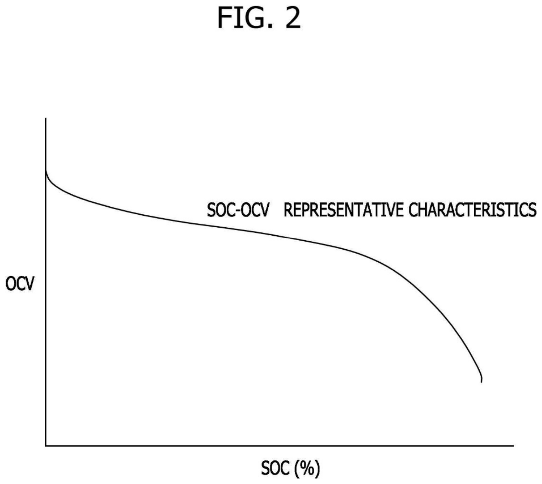

For example, in a battery pack including three battery cells, the SOC-OCV characteristics of the battery cells may be assumed as illustrated in FIG. 2. FIG. 2 is a view illustrating an SOC-OCV characteristic curve according to embodiments of the present invention.

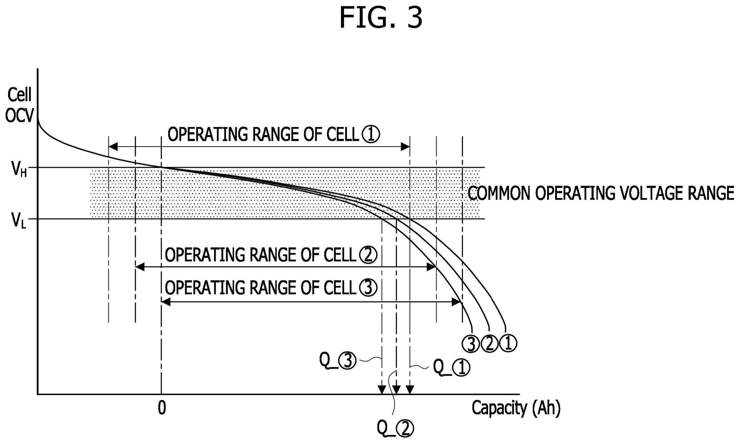

However, when it is assumed that actual battery cells are represented by battery cell capacity (Ah) rather than SOC and the actual operating ranges are slightly different, the result is as illustrated in FIG. 3.

FIG. 3 is a view illustrating a capacity (Ah)-OCV characteristic curve according to embodiments of the present invention.

Referring to FIG. 3, it may be assumed that battery cell 1 (cell ①) has the largest capacity and operates within the highest voltage range, battery cell 2 (cell ②) has an intermediate capacity and operates within an intermediate voltage range, and battery cell 3 (cell ③) has the smallest capacity and operates within the lowest voltage range.

Here, the common operating voltage range of the three battery cells (cells ①, ②, ③) may range from a discharge upper limit voltage V_{H} of battery cell 3 (cell ③), which has the lowest operating voltage range, to a discharge lower limit voltage V_{L} of battery cell 1 (cell ①), which has the highest operating voltage range.

When the internal state of a battery cell is estimated using the voltage and current of existing battery cells, the voltage of the battery cell fluctuates significantly with current fluctuations, and thus, a stable voltage characteristic curve, such as the OCV curve, cannot be obtained when current fluctuations are significant. In addition, voltage drops (voltage increases during charge) due to internal resistance can result in significant differences from the actual OCV, depending on the amount of current. For this reason, reliably obtaining partial capacity within a predetermined voltage range is extremely difficult in real-world usage and is only feasible in extremely limited circumstances (e.g., a usage environment in which low-rate charge is continuously performed, or low-rate discharge is continuously performed). Accordingly, in the embodiments, a value closer to the OCV may be obtained by using the H parameter that has low variability with respect to current and is less affected by current.

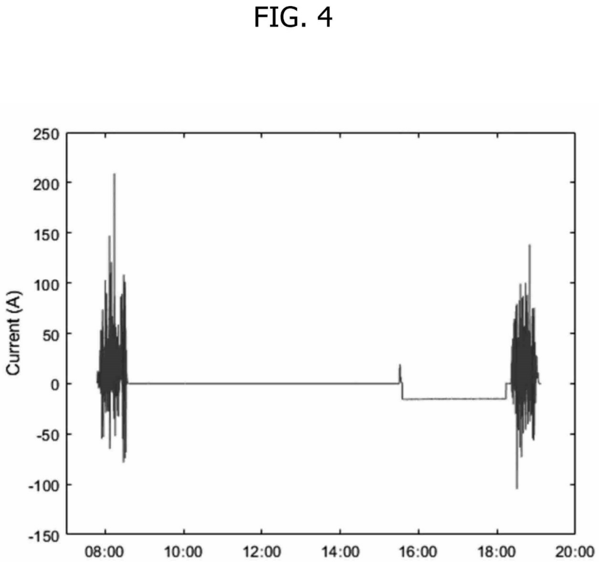

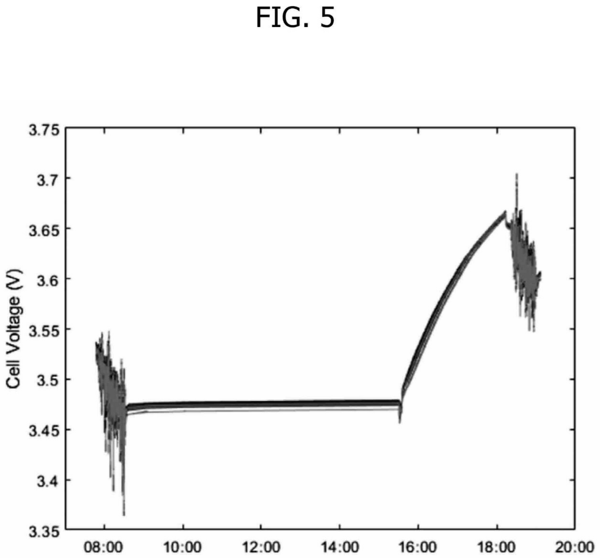

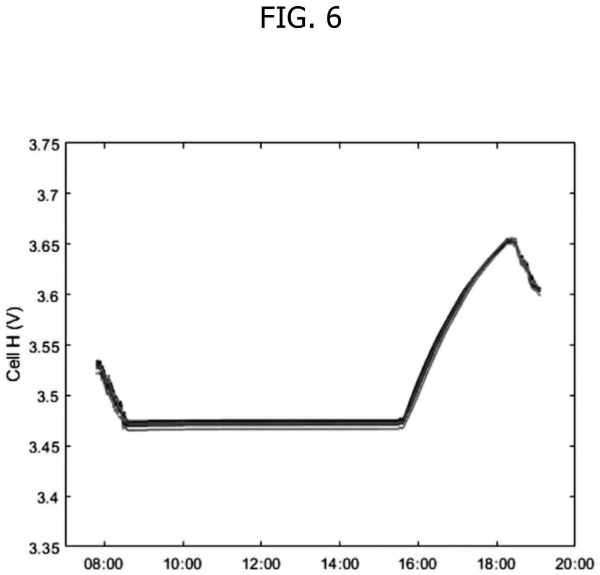

FIG. 4 is a view illustrating a vehicle battery pack current according to embodiments of the present invention, FIG. 5 is a view illustrating voltages of the battery cells according to embodiments of the present invention, and FIG. 6 is a view illustrating the H parameter characteristics of the battery cells according to embodiments of the present invention.

FIG. 4 illustrates operating data of an electric vehicle (EV) having current charge/discharge operation characteristics and illustrates that driving and charge are partially repeated throughout the day. Based on the current pattern, it can be seen that the EV actually drove from 7:30 AM to about 9:00 AM, and from 6:00 PM to about 7:30 PM. Here, due to the characteristics of the driving environment, the current applied to the battery pack fluctuates significantly due to repeated acceleration, deceleration, and stopping. It can be seen that charge starts at about 3:30 PM and ends at about 6:00 PM and charge is continuously performed at a constant current.

In contrast, in the case of the battery cell voltage, as illustrated in FIG. 5, it can be seen that significant fluctuations occur in the cell voltage when current fluctuates significantly depending on driving conditions. Accordingly, while such an approach is applicable in cases in which the current is relatively constant, such as during charge, it can be seen that, in cases in which voltage fluctuations are significant, such as during general driving, it is very difficult to calculate a partial capacity based on the common operating voltage range. That is, since voltage fluctuations caused by the operating current are significant, there is a disadvantage that it is difficult to obtain a partial capacity.

Accordingly, in the embodiments, as illustrated in FIG. 6, since characteristics similar to the OCV movement may be obtained using the H parameter, a constant operating voltage range can be found, and this can be used to more accurately estimate the battery cell dispersion based on the partial capacity.

Meanwhile, the processor 300 may calculate the partial capacity in the common operating voltage range of the charge cycle or discharge cycle. This will be described with reference to FIG. 3. In the embodiments, the discharge cycle will be described as an example.

In the case of the discharge cycle, when discharge of battery cells 1, 2, and 3 starts, the processor 300 measures the partial discharge capacities of battery cells 1, 2, and 3 within the common operating voltage range. Accordingly, for battery cells 1 and 2, in practice, even when discharge has already started earlier, the processor 300 may measure the partial discharge capacity within the common operating voltage range and thus determine that discharge amounts from the discharge upper limit voltage to the discharge lower limit voltage within the common operating voltage range are partial discharge capacities Q_① and Q_②. In addition, for battery cell 3, the processor 300 may determine that a discharge amount within the common operating voltage range from the discharge upper limit voltage within the common operating voltage range is a partial discharge capacity Q_③.

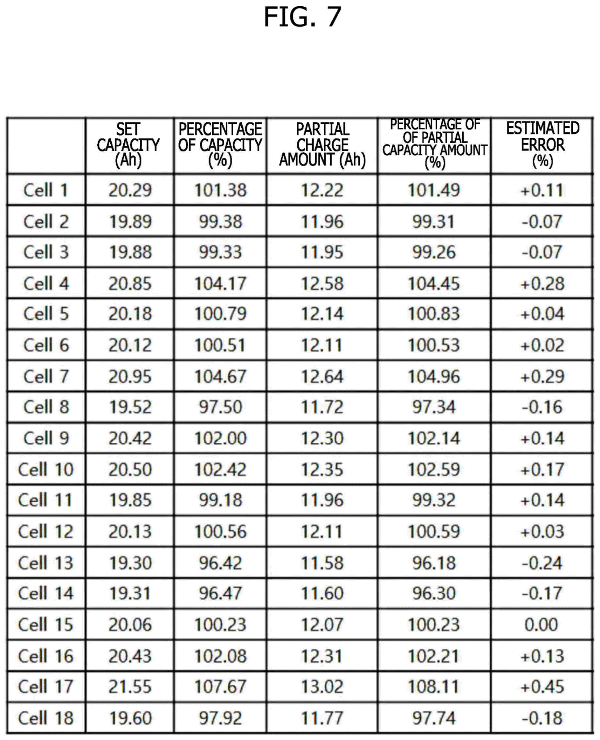

Subsequently, the processor 300 may calculate a partial discharge capacity percentage for each battery cell using the partial discharge capacity of each battery cell. That is, the processor 300 may calculate an average partial discharge capacity by summing the partial discharge capacities of the battery cells and then calculate the percentage of the partial discharge capacity of each battery cell with respect to the average. Accordingly, the processor 300 may obtain the dispersion of the partial discharge capacities of the battery cells within the battery pack, as illustrated in FIG. 7. Here, the capacity dispersion of the battery cell may be the partial capacity of each battery cell with respect to the average partial capacity of the battery cells.

This process may also be applied to the dispersion of the partial charge capacity of the battery cells.

FIG. 7 is a veiw illustrating dispersion estimation results of the battery cells according to embodiments of the present invention.

FIG. 7 illustrates the partial charge capacities (partial charge amount (%)) of battery cells Cell 1 to 18 and also illustrates set capacities, capacity percentages, partial charge amounts, and estimation errors of the battery cells Cell 1 to 18.

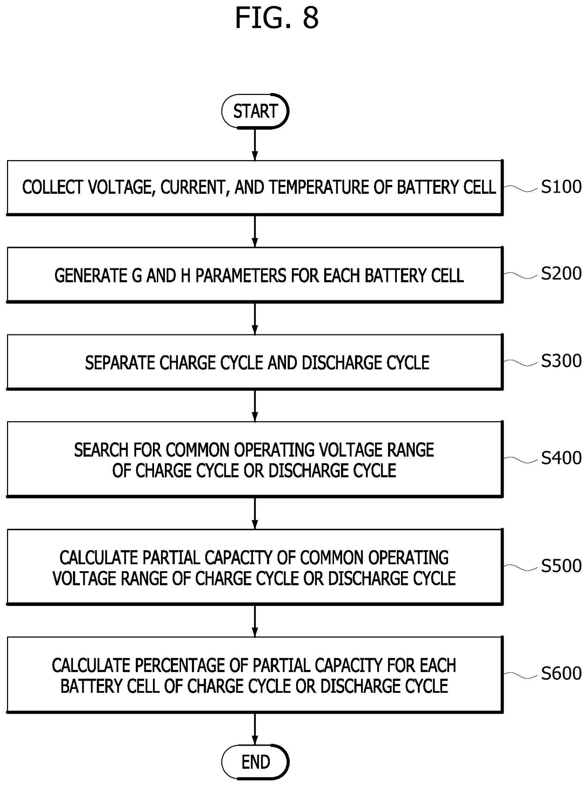

Hereinafter, a method of estimating capacity dispersion of a battery cell according to embodiments of the present invention will be described in detail with reference to FIG. 8.

FIG. 8 is a flowchart of a method of estimating capacity dispersion of a battery cell according to embodiments of the present invention.

Referring to FIG. 8, the processor 300 may collect the states of the battery cells through the data collection unit 100 first (S100). The states of the battery cell may be a voltage, current, or temperature of the battery cell.

The processor 300 may generate the G and H parameters using the state of the battery cells (S200).

The processor 300 may use the generated H parameter of each battery cell to separate the charge and discharge cycles (S300).

The processor 300 may search for the common operating voltage range for each cycle (S400). That is, the processor 300 may search for the common operating voltage range for each charge or discharge cycle. Here, the common operating voltage range of the discharge cycle may be a range between the operating upper limit voltage of the battery cell having the lowest operating voltage range among the battery cells and the operating lower limit voltage of the battery cell having the highest operating voltage range among the battery cells. The common operating voltage range of the charge cycle may be a range between the operating lower limit voltage of the battery cell having the highest operating voltage range among the battery cells and the operating upper limit voltage of the battery cell having the lowest operating voltage range among the battery cells.

Subsequently, the processor 300 may calculate the partial capacity of the common operating voltage range for each cycle (S500). That is, the processor 300 may calculate the partial charge capacity of the common operating voltage range of the charge cycle and the partial discharge capacity of the common operating voltage range of the discharge cycle. In an embodiment, the processor 300 may estimate the capacity dispersion of the battery cell based on a ratio of the partial capacity of each battery cell to the common operating voltage range.

The processor 300 may average the partial charge capacities of the common operating voltage range of the charge cycle, and based on this, calculate the percentage of the partial charge capacity of each battery cell, thereby estimating the dispersion of the battery cells. In an embodiment, the capacity dispersion of the battery cell may be represented by a percentage of the partial capacity of each battery cell with respect to an average partial capacity of the battery cells. In addition, the processor 300 may average the partial discharge capacities of the common operating voltage range of the discharge cycle, and based on this, calculate the percentage of the partial discharge capacity of each battery cell, thereby estimating the dispersion of the battery cells.

As described herein, according to embodiments of the present invention, the relative capacity difference between the battery cells in the battery pack may be extracted using the charge/discharge data in the actual usage environment.

According to embodiments of the present invention, the relative capacity difference between battery cells in a battery pack can be extracted using charge/discharge data in an actual usage environment.

However, effects that can be achieved through the present invention are not limited to the herein-described effects and other effects that are not described may be clearly understood by those skilled in the art from the detailed descriptions.

The term "unit" as used herein may include a unit implemented in hardware, software, or firmware, and may be used interchangeably with terms such as logic, logic block, component, or circuit. A "unit" may be an integral component or the smallest unit or part thereof performing one or more functions. For example, according to embodiments, a "unit" may be implemented in the form of an ASIC (Application-Specific Integrated Circuit).

The embodiments described herein may be implemented, for example, as a method or process, a device, a software program, a data stream, or a signal. Although discussed in the context of a single type of implementation (for example, discussed only as a method), features discussed herein may also be implemented in other forms (for example, a device or a program). The device may be implemented by suitable hardware, software, firmware, and the like. The method may be implemented on a device, such as a processor that generally refers to a processing device including a computer, a microprocessor, an integrated circuit, a programmable logic device, etc. The processor includes a communication device such as a computer, a cell phone, a personal digital assistant (PDA), and other devices that facilitate communication of information between the device and end-users.

Although the present invention has been described with reference to embodiments and drawings illustrating aspects thereof, the present invention is not limited thereto.

## Claims

1. An apparatus for estimating capacity dispersion of a battery cell, the apparatus comprising:
a data collection unit (100) configured to collect a state of a battery cell;
a processor (300); and
a memory (200) configured to store instructions executed by the processor (300),
wherein the processor (300) calculates a partial capacity of each battery cell with respect to a common operating voltage range of battery cells based on a voltage of each battery cell and estimates a capacity dispersion of the battery cell using the partial capacity of each battery cell.

2. The apparatus of claim 1, wherein the capacity dispersion of the battery cell is estimated for each charge capacity or discharge capacity of the battery cell.

3. The apparatus of claim 1 or 2, wherein a voltage information of the battery cell includes an H parameter of the battery cell.

4. The apparatus of any of claims 1 to 3, wherein the common operating voltage range is a voltage range in which the battery cells operate commonly and is set based on an operating voltage range of the battery cell.

5. The apparatus of any of claims 1 to 4, wherein the processor (300) divides the common operating voltage range into a charge cycle and a discharge cycle using the H parameter of the battery cell.

6. The apparatus of any of claims 1 to 5, wherein, in a case of the discharge cycle, the common operating voltage range is a range between an operating upper limit voltage of a battery cell having a lowest operating voltage range among the battery cells and an operating lower limit voltage of a battery cell having a highest operating voltage range among the battery cells.

7. The apparatus of any of claims 1 to 5, wherein, in a case of the charge cycle, the common operating voltage range is a range between an operating lower limit voltage of a battery cell having a highest operating voltage range among the battery cells and an operating upper limit voltage of a battery cell having a lowest operating voltage range among the battery cells.

8. The apparatus of any of claims 1 to 7, wherein the processor (300) estimates the capacity dispersion of the battery cell based on a ratio of the partial capacity of each battery cell to the common operating voltage range.

9. The apparatus of any of claims 1 to 8, wherein the capacity dispersion of the battery cell is represented by a percentage of the partial capacity of each battery cell with respect to an average partial capacity of the battery cells.

10. A method of estimating a capacity dispersion of a battery cell, the method comprising:
calculating, by a processor (300), a partial capacity of each battery cell with respect to a common operating voltage range of battery cells based on voltage information of the battery cell; and
estimating, by the processor (300), the capacity dispersion of the battery cell using the partial capacity of each battery cell.

11. The method of claim 10, wherein the capacity dispersion of the battery cell is estimated for each charge capacity or discharge capacity of the battery cell.

12. The method of claim 10 or 11, wherein the voltage information of the battery cell includes an H parameter of the battery cell.

13. The method of any of claims 10 to 12, wherein the common operating voltage range is a voltage range in which the battery cells operate commonly and is set based on an operating voltage range of the battery cell.

14. The method of any of claims 10 to 13, wherein the processor (300) divides the common operating voltage range into a charge cycle and a discharge cycle using an H parameter of the battery cell.

15. The method of any of claims 10 to 14, wherein, in the estimating of the capacity dispersion of the battery cell,
the processor (300) estimates the capacity dispersion of the battery cell based on a ratio of the partial capacity of each battery cell to the common operating voltage range.
